# EUROPÄISCHE PATENTANMELDUNG

(11) **EP 1 154 573 A1**
(43) Veröffentlichungstag der Anmeldung: **14.11.2001**
(21) Anmeldenummer: 01111329.7
(22) Anmeldetag: 09.05.2001
(51) Int. Cl.: H03K 17/96

(54) **Berührungssensitive Steuerungsbaugruppe**

(30) Priorität: 10.05.2000 DE 20008425 U
(71) Anmelder: Diehl AKO Stiftung & Co. KG, 88239 Wangen (DE)
(72) Erfinder: Brechtelsbauer, Herbert, 91166 Georgensgmünd (DE); Krügel, Karlheinz, 91338 Igensdorf (DE); Nega, Heinrich, 91257 Pegnitz (DE); Kotouczek, Alfred, 90571 Schwaig (DE); Hammelsbacher, Karlheinz, 91126 Schwabach (DE)
(74) Vertreter: Hofmann, Gerhard, Dipl.-Ing. Patentassessor

(57) **Zusammenfassung**

Es wird eine berührungssensitive Steuerungsbaugruppe für einen Elektrokochherd mit einer Glaskeramik-Kochplatte vorgeschlagen. Die Steuerungsbaugruppe weist eine Leiterplatte auf, welche unterhalb der Glaskeramikkochplatte angebracht ist, berührungssensitve Elemente in Form von Infrarot-Sendern und Infrarot-empfindlichen Empfänger aufweist, welche auf der Leiterplatte jeweils benachbart befestigt und verdrahtet sind, und durch Berühren der Oberseite der Glaskeramikplatte oberhalb der berühungssensitiven Bauelemente ansteuerbar ist. Zwischen die Leiterplatte und die Glaskeramikplatte ist eine Matte eingebracht, welche den Zwischenraum zwischen beiden zumindest über einen Großteil der Fläche der Leiterplatte ausfüllt und Aussparungen zumindest für die Infrarot-Sender und Infrarot-empfindlichen Empfänger aufweist.

## Beschreibung

Die Erfindung betrifft eine berührungssensitive Steuerungsbaugruppe nach dem Oberbegriff des Schutzanspruchs 1.

Bei Elektrokochherden mit Glaskermik-Kochplatte ist es Stand der Technik, daß die Bedienung der Herdplatten durch Berühren von Tasten erfolgt, welche auf der Glaskeramikplatte aufgedruckt sind. Dabei sitzt die Steuerungsbaugruppe unterhalb der Glaskeramikplatte und weist Sensoren auf, welche das Berühren der Oberseite der Glaskeramikplatte durch die den Kochherd bedienende Person detektieren und entsprechende Schalt- bzw. Regelfunktionen ansteuern. Bei diesen berührungssensitiven Sensoren handelt es sich um induktive oder optische Sensoren. Im Fall der optischen Sensoren werden dazu Infrarot-Lichtquellen und Infrarot-empfindliche Empfänger verwendet, wobei ein Sensorelement jeweils aus einem Sender und einem Empfänger besteht und der Empfänger im Fall der Berührung der Glaskeramik-Oberfläche das vom Sender abgestrahlte und z. B. von dem berührenden Finger reflektierte Infrarotlicht detektiert.

Diese aus Sender und Empfänger bestehenden Sensorelemente müssen zum einen gegeneinander und zum anderen auch gegen Streustrahlung abgeschottet werden. Dazu wird jedes Sensorelement durch ein einzelnes Kunststoff-Rähmchen eingefaßt, welche von der die Sensorelemente tragenden Leiterplatte bis zu der Glaskermikplatte reichen.

Bei einer normalen Steuerungsbaugruppe für vier Herdplatten, welche mindestens zehn Sensorelemente aufweist, werden so zehn Kunststoff-Rähmchen benötigt, welche manuell auf die Sensorelemente gesteckt werden müssen, was sehr aufwendig ist.

Ausgehend von dem genannten Stand der Technik liegt der Erfindung die Aufgabe zugrunde, eine Steuerungsbaugruppe zu schaffen, bei welcher die optische Abschottung der Sensorelemente gegeneinander und gegen störendes Streulicht gewährleistet, aber dennoch eine einfache Montage ermöglicht ist.

Diese Aufgabe wird durch eine Steuerungsbaugruppe mit den Merkmalen des Schutzanspruchs 1 gelöst. Die abhängigen Unteransprüche erläutern Ausführungsformen und Weiterbildungen der Erfindung.

Durch das Einbringen einer Matte zwischen der die Sensorelemente tragenden Leiterplatte und der Glaskeramikplatte, wobei sich die Matte zumindest über einen Großteil der Leiterplattenfläche erstreckt, Aussparungen für die Sensorelemente aufweist und den Zwischenraum zwischen Leiterplatte und Glaskeramikplatte ausfüllt, ist eine wirkungsvolle Abschottung der Sensorelemente gegeben. Vorzugsweise sind die Aussparungen in der Matte für Sender und Empfänger eines Sensorelementes separat ausgeführt, so daß der Empfänger auch kein Streulicht vom benachbarten Sender empfangen kann. Falls auf der Oberseite der Leiterplatte weitere Bauelemente aufgebracht sind, weist die Matte auch für diese Bauelemente zusätzliche Aussparungen auf. Die Aussparungen können mittels Wasserschneiden, Stanzen oder Formgießen erzeugt sein. Vorzugsweise besteht die Matte aus elektrisch isolierendem Material wie Gummi, Zellporon oder Silikonschaum. In Weiterbildung der Erfindung ist die Matte federnd ausgeführt, so daß sie sich leicht an die Leiterplatte und an die Glaskeramikplatte anschmiegt, ohne daß die Leiterplatte mit besonderen Hilfsmitteln wie Federn o. ä. gegen die Glaskeramikplatte gedrückt werden muß. Als Infrarot-Sender werden bevorzugt Infrarot-Leutchdioden und als Infrarot-empfindliche Empfänger vorzugsweise Fotozellen oder Fotoresistoren verwendet, welche mit einem Tageslichtfilter abgedeckt sind.

Anhand eines Ausführungsbeispiels wird die Erfindung im folgenden näher erläutert.

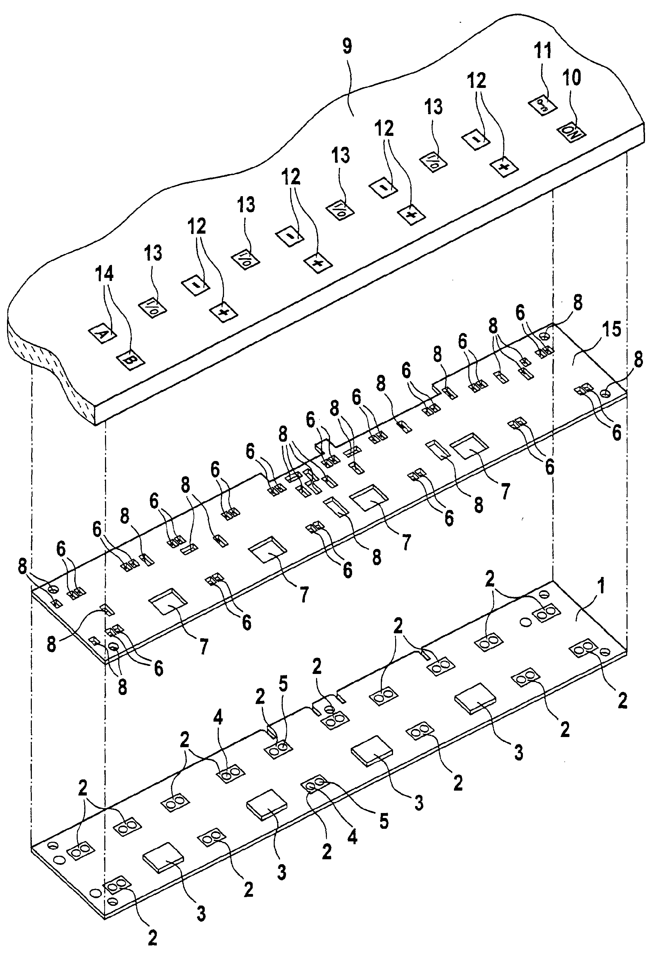

Die Figur zeigt eine berührungssensitive Steuerungsbaugruppe in perspektivischer Explosionsdarstellung.

Eine Leiterplatte 1 trägt auf ihrer Oberseite Sensorelemente 2 und Anzeigeelemente 3. Die Sensorelemente 2 und Anzeigeelemente 3 sind (auf der Unterseite der Leiterplatte 1) mit einer (nicht gezeichneten) Auswerteelektronik verbunden, welche die Signale der Sensorelemente auswertet, entsprechende Signale an eine Steuereinheit zur Ansteuerung von Kochplatten eines Elektrokochherdes weitergibt und die Anzeigeelemente 3 ansteuert. Die Sensorelemente 2 bestehen aus jeweils einer Infrarot-Leuchtdiode 4 und einem mit einem Tageslichtfilter abgedeckten Fotoresistor 5. Die Anzeigeelemente 3 sind als Sieben-Segment-Anzeigen ausgeführt.

Auf die Oberseite der Leiterplatte 1 wird eine Gummimatte 15 gelegt, welche im wesentlichen dieselben Ausmaße wie die Leiterplatte 1 besitzt und etwa 2mm stark ist. Die Matte 15 weist Ausnehmungen 6, 7 und 8 auf. Die Ausnehmungen 6 kommen auf den die Sensorelemente 2 bildenden Leuchtdioden 4 und Fotoresistoren 5 zu liegen. Die Ausnehmungen 7 fassen die Anzeigeelemente 3, welche von der Leiterplatte etwa 2mm in die Höhe ragen. Die übrigen Ausnehmungen 8 dienen der Einfassung weiterer Bauelemente, welche auf der Oberseite der Leiterplatte 1 aufbauend befestigt sind (nicht gezeichnet), bzw. der Befestigung zusammen mit der Leiterplatte 1. Auf diese Weise kommt die Matte 15 vollflächig auf der Oberseite der Leiterplatte 1 zu liegen.

Zusammen mit der Matte 15 wird die Leiterplatte 1 von unten an eine Glaskeramikplatte 9 angedrückt. Auf der Oberseite der Glaskeramikplatte 9 sind oberhalb der jeweiligen Sensorelemente Symbole 10 bis 14 aufgedruckt, welche der Funktion der jeweiligen Sensorelemente zugeordnet sind. Im zusammengebauten Zustand bilden diese Symbole 10 bis 14 zusammen mit den darunter liegenden Sensorelementen berührungssensitive Tasten.

Zur Bedienung des Kochherdes sind folgende Tasten (Symbole 10 bis 14) vorgesehen: Eine Taste (Symbol 10) zum Ein- und Ausschalten des Herdes, eine Taste (Symbol 11) zum Sperren und Entsperren der Steuerungsbaugruppe, jeweils zwei Tasten (Symbol 12) zum Erhöhen (+) und Erniedrigen (-) der Kochstufe und eine Taste (Symbol 13) zum Ein- und Ausschalten für jede einzelne Kochplatte sowie zwei Tasten (Symbol 14) zum Zuschalten zweier Zweikreis-Kochplatten.

Berührt eine Bedienperson nun eine solche Taste z. B. mit einem Finger, so wird das von der Leuchtdiode 4 des darunter liegenden Sensorelementes 5 ausgesandte Infrarot-Licht an der Grenzfläche zwischen der Oberseite der Glaskeramikplatte 9 und dem Finger der Bedienperson reflektiert und das reflektierte Licht von dem Fotoresistor 5 desselben Sensorelementes 2 detektiert. Auf diese Weise wird festgestellt, ob und gegebenenfalls wie lange die jeweilige Taste von der Bedienperson berührt, d. h. bedient wird.

Dabei bewirkt die Matte 15, daß zum einen das Licht der Fotodioden 4 zur Oberseite der Glaskeramikplatte 9 und von dort auch wieder zurück zu den Fotoresistoren 5 gelangt, und zum anderen, daß die Fotoresistoren 5 nicht durch Streulicht (Licht von Leuchtdioden 4 benachbarter Sensorelemte 2 oder schräg einfallendes Umgebungslicht) gestört werden. Zudem gelangt das Licht der Anzeigeelemente 3 durch die Ausnehmungen 7 in der Matte 15 ungehindert zur Glaskeramikplatte 9, so daß die Bedienperson die entsprechende Anzeige ablesen kann.

Die Matte 15 kann außer aus Gummi auch aus Zellporon (Poron mit Lufteinschlüssen), Silikon-Schaum oder einem anderen Material bestehen, bei dem gewährleistet ist, daß bei den hohen auftretenden Temperaturen unterhalb der Glaskeramikplatte eines Elektrokochherdes (ca. 80 bis 110° Celsius) kein Schrumpfungsprozeß auftritt. Die Aussparungen 6 bis 8 in der Matte 15 können durch Wasserschneiden, Stanzen oder gleich beim Formgießen der Matte 15 selbst erzeugt werden.

Alternativ zur beschriebenen Ausführungsform können die Ausnehmungen 6 auch derart ausgeführt sein, daß Leuchtdiode 4 und Fotoresistor 5 eines Sensorelementes 2 nicht von voneinander getrennten Ausnehmungen 6 sondern von einer gemeinsamen Ausnehmung 6 gefaßt sind.

In Weiterbildung der gezeigten Ausführungsform kann die Matte 15 federnd ausgeführt sein, so daß auch ohne stärkeres Andrücken der Leiterplatte 1 an die Glaskeramikplatte 9 gewährleistet ist, daß der Zwischenraum zwischen Oberseite der Leiterplatte 1 und Unterseite der Glaskeramikplatte 9 vollständig von der Matte 15 ausgefüllt ist.

## Patentansprüche

1. Berührungssensititve Steuerungsbaugruppe für einen Elektrokochherd mit einer Glaskeramik-Kochplatte, wobei die Steuerungsbaugruppe eine Leiterplatte aufweist, die unterhalb der Glaskeramikplatte angebracht ist, als berührungssensitive Elemente Infrarot-Sender und Infrarot-empfindliche Empfänger aufweist, die auf der Leiterplatte jeweils benachbart befestigt und verdrahtet sind, und durch Berühren der Oberseite der Glaskeramikplatte oberhalb der berührungssensitiven Bauelemente ansteuerbar ist,
**dadurch gekennzeichnet,**
**daß** zwischen der Leiterplatte (1) und der Glaskeramikplatte (9) eine Matte (15) eingebracht ist, die den Zwischenraum zwischen Leiterplatte (1) und Glaskeramikplatte (9) zumindest über einen Großteil der Fläche der Leiterplatte (1) ausfüllt und Aussparungen (6) für die Infrarot-Sender (4) und Infrarot-empfindlichen Empfänger (5) aufweist.

2. Berührungssensititve Steuerungsbaugruppe nach Anspruch 1,
**dadurch gekennzeichnet,**
**daß** für die Infrarot-Sender (4) und Infrarot-empfindlichen Empfänger (5) voneinander getrennte Aussparungen (6) in der Matte vorgesehen sind.

3. Berührungssensititve Steuerungsbaugruppe nach Anspruch 1,
**dadurch gekennzeichnet,**
**daß** für jeweils ein aus einem Infrarot-Sender (4) und einem Infrarot-empfindlichen Empfänger (5) bestehendes berührungssensitives Element (2) eine Aussparung (6) in der Matte (15) vorgesehen ist.

4. Berührungssensititve Steuerungsbaugruppe nach einem der Ansprüche 1 bis 3,
**dadurch gekennzeichnet,**
**daß** die Matte (15) zusätzlich Aussparungen (7, 8) für alle auf der Oberseite der Leiterplatte (1) befindlichen Bauteile aufweist.

5. Berührungssensititve Steuerungsbaugruppe nach einem der vorherigen Ansprüche,
**dadurch gekennzeichnet,**
**daß** die Aussparungen (6, 7, 8) in der Matte (15) mittels Wasserschneiden, Stanzen oder Formgießen erzeugt sind.

6. Berührungssensititve Steuerungsbaugruppe nach einem der vorherigen Ansprüche,
**dadurch gekennzeichnet,**
**daß** die Matte (15) aus elektrisch isolierendem Material besteht.

7. Berührungssensititve Steuerungsbaugruppe nach einem der vorherigen Ansprüche,
**dadurch gekennzeichnet,**
**daß** die Matte (15) aus Gummi, Zellporon oder Silikonschaum besteht.

8. Berührungssensititve Steuerungsbaugruppe nach einem der vorherigen Ansprüche,
**dadurch gekennzeichnet,**
**daß** die Matte (15) federnd ausgeführt ist.

9. Berührungssensititve Steuerungsbaugruppe nach einem der vorherigen Ansprüche,
**dadurch gekennzeichnet,**
**daß** die Infrarot-Sender (4) Infrarot-Leuchtdioden und die Infrarot-empfindlichen Empfänger (5) mit Tageslichtfilter abgedeckte Fotozellen oder Fotoresistoren sind.
